(19) **Europäisches Patentamt European Patent Office Office européen des brevets**

(11) **EP 1 622 177 B1**

(12) **FASCICULE DE BREVET EUROPEEN**

(45) Date de publication et mention
de la délivrance du brevet:
**09.09.2009 Bulletin 2009/37**

(51) Int Cl.:
*H01F 41/30* (2006.01)    *H01F 41/18* (2006.01)
*H01F 10/13* (2006.01)    *H01F 10/00* (2006.01)
*H01F 17/00* (2006.01)    *H01L 23/552* (2006.01)

(21) Numéro de dépôt: **05291583.2**

(22) Date de dépôt: **25.07.2005**

(54) **Film mince magnétique doux à forte aimantation, son procédé d'obtention et circuit intégré correspondant**

Weichmagnetischer Film mit hoher Magnetisierungsfähigkeit, Herstellungsverfahren und entsprechende integrierte Schaltung

Soft magnetic film having a high magnetization, methof for manufacturing thereof and corresponding integrated circuit

(84) Etats contractants désignés:
**DE FR GB IT**

(30) Priorité: **27.07.2004 FR 0408289**

(43) Date de publication de la demande:
**01.02.2006 Bulletin 2006/05**

(73) Titulaires:
• **STMicroelectronics SA**
**92120 Montrouge (FR)**
• **COMMISSARIAT A L'ENERGIE ATOMIQUE**
**75015 Paris (FR)**

(72) Inventeurs:
• **Bouche, Guillaume**
**Portland, Oregon 97209 (US)**
• **Ancey, Pascal**
**38420 Revel (FR)**
• **Viala, Bernard**
**38360 Sassenage (FR)**
• **Couderc, Sandrine**
**38000 Grenoble (FR)**

(74) Mandataire: **Zapalowicz, Francis**
**Bureau Casalonga & Josse**
**Bayerstrasse 71/73**
**80335 München (DE)**

(56) Documents cités:
**EP-A- 1 020 878**

• **ROOZEBOOM F ET AL: "Soft-magnetic fluxguide materials" PHILIPS JOURNAL OF RESEARCH, ELSEVIER, AMSTERDAM, NL, vol. 51, no. 1, 1998, pages 59-91, XP004124674 ISSN: 0165-5817**

**Description**

L'invention concerne l'obtention de films granulaires, magnétiques doux, à forte aimantation et isolants, ainsi que leurs applications possibles dans le domaine de la microélectronique et plus particulièrement dans les applications radio fréquence (RF).

Au sens de l'invention, par "film granulaire", on entend un film constitué de deux phases, la première étant généralement dispersée dans la seconde. La première phase est ici cristalline et la seconde amorphe.

Par « film magnétique doux », on entend un film possédant un caractère facilement réversible de son aimantation caractérisé entre autre par un faible champ coercitif ($Hc \leq 5$ Oe).

Par "forte aimantation", on entend un film possédant une aimantation à saturation élevée ($Ms > 1$ T). Par "film isolant ", on entend un film à caractère très faiblement conducteur, c'est-à-dire une résistivité $\rho \geq 500$ $\mu\Omega.cm$, et par exemple $\rho \geq 10^3$ $\mu\Omega.cm$.

Par "film magnétique pour applications RF", on sous-entend un film satisfaisant à la théorie classique de rotation cohérente d'aimantation décrit par le célèbre modèle de Landau-Lifshitz-Gilbert, sur la base de l'existence d'une anisotropie magnétique uniaxiale induite caractérisée par un champ d'anisotropie ($Hk > Hc$).

Le brevet américain US5573863 décrit des films d'alliages magnétiques doux comprenant une phase nanocristalline consistant essentiellement de Fe cubique et une phase amorphe comprenant un éléments de terre rare ou Ti, Zr, Hf, V, Nb, Ta ou W et de l'oxygène en quantité importante, les deux phases se présentant sous forme de mélange. Le choix du fer est justifié pour son aimantation élevée.

La solution décrite s'appuie sur le caractère amorphisant connu des alliages FeX avec $X \geq 15$ % en poids où X représente Ti, Zr, Hf, V, Nb, Ta ou W déposés par pulvérisation. Les propriétés magnétiques adéquates sont classiquement obtenues après cristallisation partielle du composé par traitement magnéto-thermique à 400°C après déposition.

Ceci permet d'obtenir une phase ferromagnétique nanocristallisée relativement dense et dispersée dans la matrice amorphe initiale. L'obtention d'une microstructure en grains ferromagnétiques fortement couplés entre eux à l'échelle nanométrique facilite en effet la condition d'obtention du caractère magnétique doux du film.

Une première difficulté consiste en une fraction volumique de la phase nanocristalline (ferromagnétique) généralement faible (< 80 %) qui ne permet pas d'obtenir une aimantation élevée. Ici, la méthode proposée rajoute au procédé connu l'aspect réactif en utilisant de l'oxygène. Ceci conduit naturellement à une oxydation du film et à une augmentation de sa résistivité. Par contre, le procédé d'oxydation n'est pas sélectif et concerne à la fois les grains et la matrice.

La seconde difficulté consiste en une réduction encore plus importante de l'aimantation à cause de l'oxydation de la phase cristalline ferromagnétique de Fe. Il en ressort une impossibilité à concilier caractère isolant et forte aimantation.

Le brevet américain US5725685 divulgue des films d'alliage magnétiques doux, similaires à ceux décrits dans le brevet US5573863, à la seule différence que la phase amorphe comprend de l'azote en quantité importante et non de l'oxygène. Ce procédé permet d'éviter le problème d'oxydation de la phase ferromagnétique et de conserver une aimantation plus forte. Par contre, les niveaux de résistivité sont nettement plus faibles du fait de l'absence d'oxydation. Il en ressort également une impossibilité à concilier caractère isolant ou fortement résistif ici ou forte aimantation.

La demande de brevet européen EP1361586 décrit une méthode de réalisation d'un film mince magnétique possédant une forte aimantation et un caractère isolant. Ce film est préparé par technique de co-pulvérisation non réactive utilisant deux cibles composées respectivement d'un alliage magnétique et d'un diélectrique. L'avantage de cette méthode repose sur un procédé non réactif (bombardement par espèces ioniques neutres uniquement) évitant l'oxydation des grains ferromagnétiques et permettant de conserver théoriquement une aimantation élevée. La méthode décrite peut être soit séquentielle (dépôts multicouches alternés), soit concomitante (co-déposition simultanée).

Le film décrit est constitué de grains ferromagnétiques nanométriques de CoFe (choisi pour sa forte aimantation) enrobés dans une matrice diélectrique composée par exemple de $Al_2O_3$ ou $SiO_2$. La difficulté ici tient au choix de l'alliage de CoFe qui n'est pas naturellement doux. Ainsi, les propriétés magnétiques douces du film ne pourront être assurées qu'à condition d'une réduction suffisante de la taille des grains de CoFe (typiquement inférieure à 10 nm) et au maintient d'un couplage intergranulaire fort qui suppose une distance entre grains relativement faible (typiquement inférieure à 5 nm).

A l'inverse, le caractère isolant nécessite un certain volume de matériau diélectrique enrobant les grains ferromagnétiques afin d'éviter un taux de percolation trop élevé. Les ajustements en termes de procédés (fractions volumiques respectives des deux phases) sont, en ce sens, antinomiques. L'utilisation d'alliages de CoFe justifiée initialement par une aimantation intrinsèque très élevée rend donc cette méthode difficile et limitative. Il en ressort une impossibilité à concilier caractère isolant et forte aimantation.

Le domaine de la microélectronique tend de plus en plus vers la diminution constante des dimensions élémentaires des composants des circuits intégrés, ce qui pose problème pour certains composants.

Actuellement, l'utilisation d'inductances, essentiellement de géométrie planaire, au sein de ces circuits RF présente une limite en termes de rapport de valeur d'inductance sur surface occupée.

L'introduction de couches ferromagnétiques à forte perméabilité ($\mu$') permet d'augmenter significativement ce rapport. Ces couches doivent répondre aux contraintes d'utilisation à haute fréquence notamment en termes dissipatifs, afin de satisfaire à un facteur de qualité élevé du composant.

Leur intégration doit donc minimiser les apports supplémentaires en pertes dont les origines sont principalement magnétiques ($\mu$'') et capacitives (C). Ces dernières proviennent de la juxtaposition de plusieurs niveaux métalliques séparés par des diélectriques nécessaires à la fabrication du composant.

La première contribution peut être minimisée par l'établissement d'une fréquence de résonance ferromagnétique élevée (FRM) grâce notamment à l'utilisation de couches à aimantation à saturation élevée. Dans certains cas, on cherchera au contraire à utiliser le pouvoir absorbant à la résonance ferromagnétique ($\mu$'' maxi) pour des fonctionnalités de blindage électromagnétique. La contribution capacitive reste la plus limitative et est difficilement contournable dans l'état de l'art actuel où les couches minces ferromagnétiques adéquates du point de vue magnétique présentent un caractère conducteur.

Actuellement, parmi les matériaux magnétiques doux connus à forte aimantation, on distingue la famille des FeXN avec X : Al, Si, Ta, Zr, Hf, Rh, Ti. A la différence du brevet US5725685, ces matériaux sont obtenus directement dans l'état nanocristallisé avec matrice amorphe par pulvérisation réactive sous flux d'azote.

L'incorporation d'atomes d'azote au cours de la croissance du film permet en effet une réduction progressive de la taille des grains (jusqu'à 5 nm) et un contrôle de la fraction volumique associée qui reste élevée ($\geq$ 90 %). Ces matériaux présentent en général une forte aimantation (de 1.8 à 2 T) et d'excellentes propriétés magnétiques douces jusqu'à plusieurs GHz.

Par contre, ils ne permettent pas d'obtenir des résultats optimaux en termes d'intégration dans des bobines inductives (selfs) RF. En effet, la résistivité ($\rho$) de ces matériaux reste trop faible, de l'ordre de 150 $\mu\Omega$.cm. Malgré la dispersion de la phase cristalline conductrice de FeXN dans une matrice amorphe résistive, le caractère global du matériau reste essentiellement conducteur.

L'utilisation d'un tel matériau conducteur pour ce type d'application est à la base de problèmes de couplage capacitif entre le plan et la bobine inductive, qui dégrade très fortement la charge et ne permet pas d'obtenir des valeurs de facteurs de qualités assez élevés (typiquement $Q \geq 30$). Les matériaux à caractère isolant de type FeXO, décrits dans la littérature, ne présentent pas quant à eux les propriétés magnétiques adéquates (aimantation trop faible).

Le document « Soft-magnetic fluxguide materials », de F. Roozeboom (Philips Journal of Research, Elsevier, Amsterdam, NL, vol. 51, no. 1, 1998, pages 59-91) décrit des matériaux de films minces magnétiques doux tels que des films nanocristallins de fer de formule générale Fe-M-X dans laquelle M représente un des métaux de transition IVa-Va et X un élément interstitiel tel B, C, N ou O.

EP-1,020,878 décrit un film magnétique de formule générale $T_a M_b X_c N_d O_c$, constitué de grains magnétiques cristallins T et d'un produit de joint de grains contenant au moins un oxyde ou un nitrure de M et de X.

Les recherches actuelles restent focalisées sur des matériaux magnétiques à forte perméabilité et isolants permettant la mise en contact d'un plan magnétique et d'une bobine inductive, voire d'encapsuler la bobine inductive, afin d'améliorer la compacité et les performances des ces composants en général.

L'invention vise à offrir un nouveau matériau présentant l'avantage d'être à la fois isolant et optimal d'un point de vue des propriétés magnétiques visées. On entend par propriétés magnétiques optimales, la combinaison d'une forte aimantation ($\geq$ 1.5 T), d'un faible champ coercitif (Hc $\leq$ 5 Oe), d'un champ d'anisotropie uniaxial (Hk $\geq$ 10 Oe). Sa propriété d'isolant permet d'éviter tout problème de couplage capacitif entre le plan magnétique et la bobine inductive, permettant ainsi d'obtenir un gain maximal ($\geq$ 100 %) sur la valeur de la bobine inductive et d'améliorer son facteur de qualité. Le film magnétique doux isolant selon l'invention n'engendre pas d'effet capacitif supplémentaire une fois intégré dans un dispositif RF.

L'invention concerne un film mince magnétique doux à forte aimantation et isolant, comprenant un substrat amorphe oxydé dans lequel sont immergés des nanograins ferromagnétiques riches en Fe. Les nanograins sont nitrurés et ont un diamètre inférieur à 10nm, et le pourcentage atomique d'azote est supérieur ou égal à 5 et inférieur ou égal à 20.

L'invention concerne également un procédé d'obtention dudit film mince magnétique doux, ledit procédé comprenant une nitruration de nanograins ferromagnétiques riches en Fe immergés dans un substrat amorphe, le taux d'enrichissement en azote se situant dans une plage de 0,1% à 10%, et une oxydation sélective du substrat amorphe.

Ainsi, selon l'invention, on prévoit en combinaison une nitruration des nanograins et une oxydation sélective du substrat amorphe constituant la matrice intercristalline. Ceci permet d'obtenir un matériau du type FeXNO comportant donc à la fois de l'oxygène et de l'azote, en évitant la problématique de l'oxydation de la phase ferromagnétique riche en Fe responsable de la réduction de l'aimantation à saturation.

Selon un mode de réalisation de l'invention, les nanograins ferromagnétiques sont constitués principalement de FeXN avec X choisi de préférence parmi les éléments suivants Zr, Nb, Mo, Ru, Rh, Pd, Hf, Ta, W, Ir et Pt. La liste peut être étendue aux éléments de la famille des terres rares (Lanthanides), ainsi qu'aux éléments suivants : Al, Si, Ti, V, Cr, Mn et Cu.

La nitruration peut être effectuée par pulvérisation réactive à partir d'une cible de FeX en présence d'azote avec application d'un champ magnétique uniaxial dans le plan du substrat.

L'oxydation peut être effectuée par pulvérisation réactive en présence d'oxygène. Ce procédé peut être réalisé en même temps que le procédé de nitruration, de façon continue ou séquentielle.

L'oxydation peut être effectuée par co-pulvérisation à partir d'une cible de XO avec X défini tel que précédemment. Ce procédé peut être réalisé en concomitance avec le procédé de nitruration, conduisant à la réalisation d'un film hétérogène constitué d'agrégats de matériaux FeXN et XO. Ce procédé peut également être réalisé séquentiellement avec le procédé de nitruration, conduisant à la réalisation d'un film hétérogène constitué d'une alternance multicouche de FeXN et XO.

Ce dernier mode de mise en oeuvre repose sur la diffusion sélective d'oxygène des agrégats ou couches de XO vers la matrice amorphe des agrégats ou couches FeXN par traitement thermique post-déposition.

L'invention concerne également un film mince magnétique selon la revendication 1, comprenant un substrat amorphe oxydé dans lequel sont immergés des nanograins ferromagnétiques riches en Fe et nitrurés.

Les nanograins peuvent par exemple constituer une phase cristalline de FeXN et le substrat amorphe peut être constitué de X ou XN, X étant tel que défini ci-dessus. Les nanograins ont un diamètre inférieur à 10 nm et ils ont, de préférence, une structure cubique centrée (bcc) ou tétragonale centrée (bct).

Selon un mode de réalisation, la phase amorphe représente moins de 20 % du volume total du film mince.

Chaque élément est présent au sein du film, par exemple, dans les proportions suivantes en pourcentage atomique : $Fe_aX_bN_cO_d$, dans lequel a+b+c+d= 100% et :

$$45\ \% \leq a \leq 90\ \%,$$

$$1\ \% \leq b \leq 5\ \%$$

$$5\ \% \leq c \leq 20\%$$

$$5\ \% \leq d \leq 30\%.$$

L'invention propose également un circuit intégré comprenant au moins un composant utilisant une membrane incorporant un film mince tel que défini ci-dessus.

Le composant est par exemple inductif et la membrane du composant inductif peut être fixe ou déplaçable.

Lorsque la membrane est fixe, la distance séparant la membrane du composant inductif peut être réduite au minimum. Le film magnétique présente de préférence une forte perméabilité magnétique $\mu'$ et de faibles pertes magnétiques $\mu''$, ce qui permet une amplification maximale de la valeur de l'inductance et un gain sur le facteur de qualité. On peut également par exemple obtenir des bobines plus petites à performance égale.

Lorsque la membrane du composant inductif est fixe, elle peut former un capot de blindage du composant inductif. Le film magnétique de la membrane présente, dans ce cas, de préférence une faible perméabilité magnétique $\mu'$ et de fortes pertes magnétiques $\mu''$ de façon à former un vrai blindage électromagnétique sans effet sur la valeur inductive du composant.

Lorsque la membrane est déplaçable, le film magnétique présente, de préférence, une forte perméabilité magnétique $\mu'$ et de faibles pertes magnétiques $\mu''$, ce qui permet un contrôle de la valeur inductive du composant en fonction de la position de la membrane par rapport aux spires.

D'autres exemples de circuits intégrés selon l'invention incluent par exemple des circuits dans lesquels la membrane forme un capot d'encapsulation du composant ou un support pour un autre composant. Le composant peut également être un composant capacitif, la membrane formant alors le diélectrique du composant capacitif.

Les circuits intégrés peuvent également comprendre deux ou plus de deux composants différents utilisant deux parties différentes de la même membrane.

Ainsi, l'invention est à cet égard particulièrement intéressante car elle permet une co-intégration de plusieurs composants sur le circuit intégré en utilisant la même membrane formée pleine plaque.

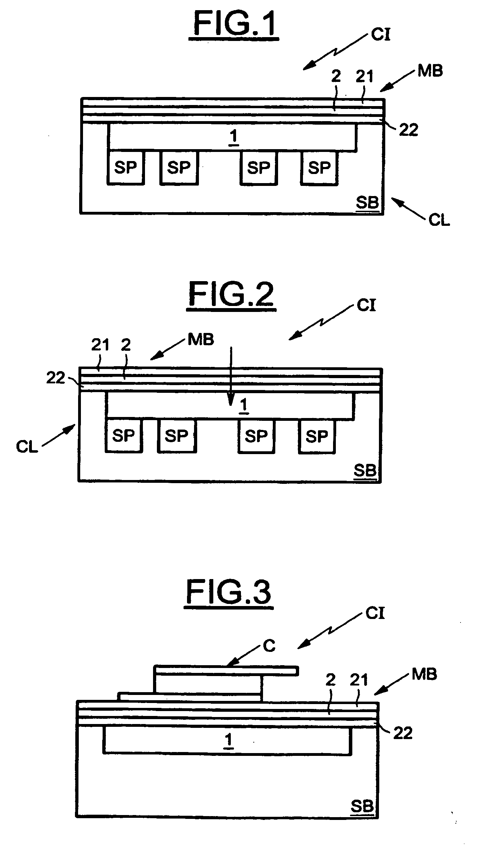

D'autres avantages et caractéristiques de l'invention apparaîtront à l'examen de la description détaillée des modes de mise en oeuvre et de réalisation, nullement limitatifs, et des dessins annexés, sur lesquels les figures 1 à 5 représentent schématiquement différents circuits intégrés comportant des composants utilisant un film mince selon l'invention.

L'invention permet d'obtenir un film mince ferromagnétique doux à forte aimantation et à caractère isolant à partir de nanograins ferromagnétiques riches en Fe immergés dans un substrat amorphe et comprend une étape de nitruration in situ des nanograins et une étape d'oxydation sélective in situ de la matrice amorphe.

Au sens de l'invention, on entend par « nanograins riches en Fe », des nanograins avec une teneur en fer supérieure à 85 % en poids.

Le procédé d'obtention d'un tel film mince peut être effectué par exemple selon deux variantes: la première consiste en une pulvérisation cathodique réactive sous flux d'azote et d'oxygène de couches de FeX ; la seconde en une diffusion sélective d'oxygène au sein d'un composé hétérogène constitué d'un ensemble d'agrégats ou de bicouches de FeXN / XO.

La première variante consiste en une pulvérisation cathodique sous flux d'azote et d'oxygène de couches de FeX.

Ces films sont élaborés par des techniques connues, par exemple par bombardement d'ions (RF/DC, diode, magnétron ou par faisceau d'ion) sous flux principal d'argon et flux secondaires d'azote et d'oxygène, à température ambiante.

La croissance des couches s'effectue sous un champ magnétique uniaxial appliqué dans le plan du substrat d'environ 100 - 200 Oe. Les conditions de dépôt optimales sont atteintes pour une pression de $3.10^{-3}$ - $5.10^{-3}$ mbar, un débit de gaz moyen de 50-100 sccm et à température ambiante.

Les procédés de nitruration et d'oxydation sont contrôlés respectivement par le biais des taux d'enrichissement en gaz secondaires (réactifs) injectés dans l'enceinte. Le taux relatif à l'enrichissement en azote est défini par le rapport : $N_2/(Ar+N_2+O_2)$ et le taux d'enrichissement en oxygène par $O_2/(Ar+N_2+O_2)$. Ces taux peuvent varier typiquement dans une plage de 0.1 % à 10 %. Les épaisseurs des films formés sont comprises entre 500 Å et 5000 Å.

La microstructure du matériau obtenu est telle que définie ci-dessous. Pour un pourcentage atomique d'azote inférieur à 5 %, la microstructure consiste en une phase unique cristalline bcc ou bct (cubique ou tétragonal centré ou en langue anglaise body-centered cubic or tetragonal) constituée de grains de FeXN.

Le diamètre moyen des grains est de l'ordre de 100 à 10 nm ne satisfaisant pas aux conditions d'obtention de propriétés magnétique douces (Hc > 10 Oe). Ces films ne possèdent pas d'anisotropie magnétique induite. Ils possèdent une aimantation à saturation naturellement élevée (Ms $\geq$ 1.9 T)

Pour un pourcentage atomique d'azote compris entre 5 % et 20 %, les films minces sont alors composés d'une nanostructure fine comprenant des grains nanométriques de FeXN bcc ou bct répartis aléatoirement dans une matrice amorphe riche en X.

L'azote est incorporé en position interstitielle dans la maille cristallographique des nanograins de FeX jusqu'à la saturation de la solution solide dans les grains (environ 15 - 20 % atomique). Cette incorporation s'accompagne d'une dilatation importante de la maille cristalline de FeX (jusqu'à 5 %) dont la conséquence est une réduction de la taille moyenne des grains.

Dans ces conditions, les grains de FeXN ont un diamètre moyen de l'ordre de 10 à 2 nm avec une distance intergranulaire moyenne de l'ordre de 5 à 1 nm. Ceci permet l'obtention de propriétés magnétiques douces telles que définies précédemment (Hc $\leq$ 5 Oe). Ces films possèdent une anisotropie magnétique induite caractérisée par un champ d'anisotropie de l'ordre de 10 à 40 Oe. Ces films conservent une aimantation à saturation élevée, typiquement de l'ordre de 1.9 à 1.5 T. La résistivité électrique des films croît avec l'augmentation de la teneur en azote jusqu'à typiquement 200 $\mu\Omega$.cm.

Au-delà de 20 % atomique, l'azote excédentaire vient se fixer dans la matrice amorphe. Cette dernière devient alors majoritaire en proportion volumique et les films tendent vers une microstructure totalement amorphe ne présentant plus de propriétés magnétiques douces (Hc > 20 Oe).

Selon le procédé de nitruration ayant conduit à la microstructure précédemment décrite, le procédé d'oxydation in situ conduit à une incorporation préférentielle de l'oxygène dans la matrice amorphe riche en X.

Pour différentes concentrations en oxygène et pour une concentration atomique en azote comprise entre 5-20 %, les films présentent la microstructure correspondante décrite précédemment avec des grains de diamètre de l'ordre de 10 à 2 nm distant d'environ 5 à 1 nm et enrobés par une matrice amorphe très fortement résistive riche en phases de types XO ou XNO. Ceci permet de conserver les propriétés magnétiques douces telles que définies précédemment (Hc $\leq$ 5 Oe) avec une forte augmentation de la résistivité électrique des films jusqu'à l'obtention d'un caractère macroscopique isolant.

Une deuxième variante consiste en la diffusion sélective d'oxygène à travers des structures hétérogènes de type FeXN + XO.

Cette diffusion sélective peut s'effectuer à travers des multicouches FeXN et XO élaborées par pulvérisation cathodique à partir d'une cible de FeX et d'une cible de XO. Ces films peuvent être obtenus par les mêmes techniques et conditions que celles énoncées ci-dessus dans le cadre de la pulvérisation cathodique réactive (première variante).

Le procédé de nitruration est contrôlé par le biais du taux d'enrichissement en azote injecté dans l'enceinte défini par : $N_2/(Ar+N_2)$, pouvant varier typiquement dans une plage de 0.1 % à 10 %. Les épaisseurs des films de FeXN formés ici sont comprises entre 20 Å et 500 Å. Les films correspondent à ceux ayant une teneur en azote comprise entre 5 et 20 % atomique tel que précédemment décrit.

Les films minces de XO sont eux aussi élaborés par des techniques connues, par exemple par bombardement d'ions (RF diode ou magnétron ou par faisceau d'ion). L'épaisseur du film de XO formé varie de 20 Å à 500 Å. Le nombre de bicouches FeXN/XO peut varier de 2 à 100.

Les recuits post-déposition (avec ou sans champ magnétique) sont réalisés dans un four sous vide secondaire. Les températures de recuit sont comprises entre 150°C et 400° C, la durée de recuit entre 1h et 8h. Le recuit permet la diffusion sélective de l'oxygène principalement vers la matrice amorphe riche en X constituant les couches de FeXN. Ainsi, le taux d'oxydation de la matrice amorphe et la résistivité des films varient selon les conditions expérimentales du recuit. La microstructure desdits films est identique à celle obtenue par la première variante, i.e. la pulvérisation cathodique sous flux d'azote et d'oxygène des couches de FeX décrite ci-dessus.

La diffusion sélective d'oxygène peut également être effectuée à travers des couches hétérogènes constituées d'agrégats de FeXN et de XO, élaborées par copulvérisation cathodique à partir d'une cible comprenant les deux constituants FeX et XO. Ces films peuvent être obtenus par les mêmes techniques et conditions que celles énoncées ci-dessus dans le cadre de la pulvérisation cathodique réactive (première variante).

Le procédé de nitruration est contrôlé par le biais du taux d'enrichissement en azote injecté dans l'enceinte défini par : $N_2/(Ar+N_2)$, pouvant varier typiquement dans une plage de 0.1 % à 10 %. Les épaisseurs des films de FeXN formés ici sont comprises entre 500 Å et 5000 Å. Les films correspondent à ceux ayant une teneur en azote comprise entre 5 et 20 % atomique tel que décrit précédemment. Les recuits post-déposition et les caractéristiques finales des films sont identiques à ceux décrits dans la première sous-variante.

D'une façon générale, le film mince magnétique doux à forte aimantation et à caractère isolant selon l'invention comprend une phase cristalline et une phase amorphe. La phase cristalline est dispersée dans la phase amorphe.

Selon le mode de réalisation, la phase cristalline est constituée de nanograins de FeXN riche en Fe avec solution solide interstitielle d'azote jusqu'à la limite de solubilité. X est choisi de préférence parmi les éléments suivants Zr, Nb, Mo, Ru, Rh, Pd, Hf, Ta, W, Ir, Pt. La liste peut être étendue aux éléments de la famille des terres rares (Lanthanides) ainsi qu'aux éléments suivants : Al, Si, Ti, V, Cr, Mn, Cu. Lesdits grains ont un diamètre inférieur à 10 nm, possèdent une structure bcc ou bct et ne sont pas oxydés.

Selon le mode de réalisation (et ses variantes), la phase amorphe est constituée principalement de X, N, et O riche en X contenant de l'azote et principalement de l'oxygène, X étant défini ci-dessus. Cette phase constitue une matrice isolante enrobant lesdits grains avec une distance intergranulaire de moins de 5 nm. Cette phase représente avantageusement moins de 20 % du volume total du film.

Soit un film de $Fe_a X_b N_c O_d$, à titre indicatif et pour X pris dans première série précédemment citée, les teneurs respectives pour chaque élément en pourcentage atomique sont comprises dans les plages suivantes : $45\% \le a \le 90\%$, $1\% \le b \le 5\%$, $5\% \le c \le 20\%$, $5\% \le d \le 30\%$ avec $a + b + c + d = 100\%$.

A titre indicatif et pour X pris dans première série précédemment citée, le tableau ci-dessous rassemble quelques caractéristiques magnétiques et électriques intéressantes selon la proportion de ces éléments dans les films obtenus selon l'invention (a, b, c et d sont donnés en pourcentage atomique).

| Composition | a | B | c | d | Ms (T) | $\rho\ (\mu\Omega.cm)$ |
|---|---|---|---|---|---|---|
| $Fe_a X_b N_c O_d$ | 45 | 5 | 20 | 30 | 0,8 | $10^3 - 10^6$ |
| | 46 | 4 | 20 | 30 | 0.9 | |
| | 47 | 3 | 20 | 30 | 1.0 | |
| | 48 | 2 | 20 | 30 | 1.1 | |
| | 49 | 1 | 20 | 30 | 1.2 | |
| | 52 | 3 | 15 | 30 | 1,3 | |
| | 57 | 3 | 10 | 30 | 1,35 | |
| | 62 | 3 | 5 | 30 | 1,4 | |
| | 67 | 3 | 5 | 25 | 1,5 | $10^3 - 10^4$ |
| | 72 | 3 | 5 | 20 | 1,55 | |
| | 82 | 3 | 5 | 10 | 1,65 | |
| | 85 | 5 | 5 | 5 | 1,7 | |

(suite)

| Composition | a | B | c | d | Ms (T) | ρ (μΩ.cm) |
|---|---|---|---|---|---|---|
| | 86 | 4 | 5 | 5 | 1,75 | |
| | 87 | 3 | 5 | 5 | 1,8 | 500 - 10³ |
| | 88 | 2 | 5 | 5 | 1,85 | |
| | 89 | 1 | 5 | 5 | 1,9 | |

Une caractéristique avantageuse de cesfilms consiste en leur résistivités qui peuvent selon les cas être de l'ordre de $10^3$ à $10^6$ μΩ.cm. De plus, l'oxydation sélective de la matrice intergranulaire riche en X, et non des grains ferromagnétiques riches en Fe, permet de conserver une forte aimantation.

Enfin, la nitruration sélective de la phase cristalline riche en Fe permet l'obtention de propriétés magnétiques douces et anisotropes adéquates. Il est donc possible d'obtenir un film magnétique doux à la fois isolant et à forte aimantation satisfaisant aux conditions d'utilisation pour des applications en régime radio-fréquence. Les films minces obtenues selon l'invention ont typiquement une épaisseur variant de $5.10^{-2}$ à 1 μm.

Des circuits intégrés peuvent être réalisés, mettant en oeuvre les films minces doux isolants selon l'invention. Les films sont incorporés dans une membrane, ladite membrane étant utilisée dans la préparation d'un composant destiné à l'élaboration d'un circuit intégré.

La figure 1 représente schématiquement un exemple de circuit intégré CI selon la présente invention comprenant comme composant C, un composant inductif CL. Le composant inductif CL comprend des spires métalliques SP placées dans un substrat SB au-dessous d'une cavité 1 creusée dans le substrat. Ledit composant inductif CL comprend également d'une membrane magnétique MB constituée d'un film mince doux magnétique 2 qui, dans ce mode de réalisation particulier, est pris en sandwich entre deux couches de passivation 21 et 22. Les couches de passivation assurant ici à la fois une protection du film 2 et une meilleure tenue mécanique de la membrane.

Les couches de passivation 21 et 22 sont réalisées aux moyens de méthodes connues avec des matériaux aussi connus, tels que ceux à base d'oxyde de silicium et de nitrure de silicium. La membrane comprend de préférence un film magnétique de type FeHfNO.

La membrane MB peut être fixe (figure 1) ou déplaçable (figure 2) en direction des spires par tout moyen connu (dilatation thermique, moyen mécaniques, piézo-électriques...). Lorsque la membrane est déplaçable, on peut modifier de façon contrôlée la valeur de l'inductance L du composant inductif CL.

Lorsque la membrane MB est fixe, la distance séparant la membrane du composant inductif RF peut être réduite au minimum. Le film magnétique 2 de la membrane présente de préférence une forte perméabilité magnétique μ' (typiquement ≥ 100) et de faibles pertes magnétiques μ'' (typiquement s 10), ce qui permet une amplification de la valeur de l'inductance (typiquement de 30 % à 120 %) et un haut facteur de qualité (typiquement Q ≥ 10). On peu également par exemple obtenir des bobines plus petites à performance égale.

Lorsque la membrane MB du composant inductif est fixe, elle peut former un capot de blindage du composant inductif. Le film magnétique 2 de la membrane présente, dans ce cas, de préférence une faible perméabilité magnétique μ' (typiquement ≤ 100) et de fortes pertes magnétiques μ'' (typiquement ≥ 500). Dans ce cas, la membrane fixe du composant actif forme un capot de blindage du composant inductif.

Cependant, lorsque la membrane MB peut être déplacée, le film magnétique 2 de la membrane présente une forte perméabilité magnétique μ' (typiquement ≥ 100), et de faibles pertes magnétiques μ'' (typiquement ≤ 10) ce qui permet un contrôle de la valeur inductive (typiquement dans une plage 0% à 100% (en rapprochant la membrane, on passe d'une valeur nominale X de l'inductance à potentiellement 2X)) du composant en fonction de la position de la membrane par rapport aux spires.

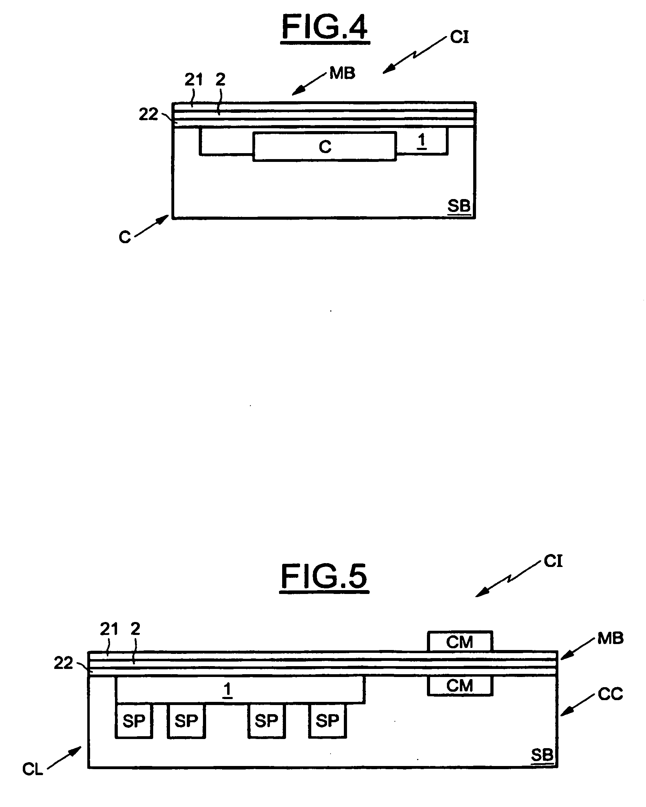

Quelle que soit la nature du composant C, la membrane MB comprenant le film 2 peut former un capot d'encapsulation du composant C. Le composant C peut être par exemple un microsystème électro-magnétique (MEMS Micro-Electro-Mechanical System) (voir figure 4). La membrane MB peut également, comme schématisé sur la figure 3, former un support pour le composant C, pouvant être par exemple un résonateur de type à ondes acoustiques de volume (BAW Bulk Acoustic Wave).

Les circuits intégrés selon la présente invention peuvent comprendre plusieurs composants identiques ou différents, utilisant deux parties différentes de la membrane, comme illustré par la figure 5.

En effet, la membrane est formée « pleine plaque », c'est-à-dire sur toute la surface du circuit intégré. Sur cette figure, le circuit comprend un premier composant inductif CL utilisant une partie de la membrane et un second composant, dans cet exemple, un composant capacitif CC pour lequel une autre partie de la membrane MB forme le diélectrique du composant disposé entre deux couches métalliques CM.

**Revendications**

1. Film mince magnétique doux à forte aimantation et isolant, comprenant un substrat amorphe oxydé dans lequel sont immergés des nanograins ferromagnétiques riches en Fe, **caractérisé en ce que** les nanograins sont nitrurés et ont un diamètre inférieur à 10nm, et **en ce que** le pourcentage atomique d'azote est supérieur ou égal à 5 et inférieur ou égal à 20.

2. Film selon la revendication 1, **caractérisé par le fait que** les nanograins constituent une phase cristalline de FeXN, X étant choisi de préférence parmi les éléments suivants Zr, Nb, Mo, Ru, Rh, Pd, Hf, Ta, W, Ir, Pt, Al, Si, Ti, V, Cr, Mn, Cu et les Lanthanides.

3. Film selon l'une quelconque des revendications 1 à 2, **caractérisé par le fait que** les nanograins ont une structure cubique ou tétragonale centrée.

4. Film selon l'une quelconque des revendications 1 à 3, prise en combinaison avec la revendication 2, **caractérisé par le fait que** le substrat amorphe est essentiellement constitué de XO ou XNO.

5. Film selon l'une quelconque des revendications 1 à 4, **caractérisé par le fait que** la phase amorphe représente moins de 20 % du volume total du film mince.

6. Film selon l'une quelconque des revendications 1 à 5, **caractérisé par le fait que** chaque élément est présent au sein du film dans les proportions suivantes en pourcentage atomique : $Fe_aX_bN_cO_d$
   $45\% \leq a \leq 90\%$,
   $1\% \leq b \leq 5\%$
   $5\% \leq c \leq 20\%$
   $5\% \leq d \leq 30\%$ avec $a+b+c+d=100\%$

7. Circuit intégré (CI), **caractérisé par le fait qu'**il comprend au moins un composant (C) utilisant une membrane (MB) incorporant un film (2) selon l'une quelconque des revendications 1 à 6.

8. Circuit intégré (CI) selon la revendication 7, **caractérisé par le fait que** le composant (C) est un composant inductif (CL).

9. Circuit intégré (CI) selon la revendication 8, **caractérisé par le fait que** la membrane (MB) du composant inductif (CL) est déplaçable de façon à faire varier la valeur inductive du composant (CL).

10. Circuit intégré (CI) selon la revendication 9, **caractérisé par le fait que** le film magnétique (2) de la membrane (MB) présente une forte perméabilité magnétique $\mu$', et de faibles pertes magnétiques $\mu$".

11. Circuit intégré (CI) selon la revendication 8, **caractérisé par le fait que** la membrane (MB) du composant inductif (CL) est fixe et forme un capot de blindage du composant inductif.

12. Circuit intégré (CI) selon la revendication 11, **caractérisé par le fait que** le film magnétique (2) de la membrane (MB) présente une faible perméabilité magnétique $\mu$', et de fortes pertes magnétiques $\mu$".

13. Circuit intégré (CI) selon l'une quelconque des revendications 8 à 12, **caractérisé par le fait que** la membrane (MB) du composant inductif (CL) incorpore un film magnétique (2) de type FeHfNO.

14. Circuit intégré (CI) selon la revendication 7, **caractérisé par le fait que** la membrane (MB) forme un capot d'encapsulation du composant (C).

15. Circuit intégré (CI) selon la revendication 7, **caractérisé par le fait que** la membrane (MB) forme un support pour le composant.

16. Circuit intégré (CI) selon la revendication 7, **caractérisé en ce que** le composant (C) est un composant capacitif (CC) et par le fait que la membrane (MB) forme le diélectrique du composant capacitif (CC).

17. Circuit intégré (CI) selon l'une quelconque des revendications 7 à 16, **caractérisé par le fait qu'**il comprend au moins deux composants (C) différents utilisant deux parties différentes de la même membrane (MB).

**18.** Circuit intégré (ÇI) selon l'une quelconque des revendications 7 à 17, **caractérisé en ce que** la membrane (MB) comporte le film magnétique (2) pris en sandwich entre deux couches de passivation (21) et (22).

**19.** Procédé d'obtention d'un film mince magnétique doux selon la revendication 1, ledit procédé comprenant une nitruration de nanograins ferromagnétiques riches en Fe immergés dans un substrat amorphe, le taux d'enrichissement en azote se situant dans une plage de 0,1% à 10%, et une oxydation sélective du substrat amorphe.

**20.** Procédé selon la revendication 19, **caractérisé par le fait que** les nanograins ferromagnétiques sont constitués de FeXN, X étant choisi de préférence parmi les éléments suivants Zr, Nb, Mo, Ru, Rh, Pd, Hf, Ta, W, Ir, Pt, Al, Si, Ti, V, Cr, Mn, Cu et les Lanthanides.

**21.** Procédé selon la revendication 19 ou 20, **caractérisé par le fait que** la nitruration est effectuée par pulvérisation réactive cathodique ou ionique.

**22.** Procédé selon la revendication 21, **caractérisé par le fait que** la nitruration est effectuée sous champ magnétique.

**23.** Procédé selon l'une des revendications 19 à 22, **caractérisé par le fait que** l'oxydation est effectuée par pulvérisation réactive cathodique ou ionique.

**24.** Procédé selon l'une des revendications 19 à 22, **caractérisé par le fait que** l'oxydation s'effectue par diffusion sélective d'oxygène par traitement thermique.

**25.** Procédé selon la revendication 24, **caractérisé par le fait que** l'étape d'oxydation comprend la formation d'une multi-couche FeXN/ XO, puis un recuit.

**26.** Procédé selon la revendication 24, **caractérisé par le fait que** l'étape d'oxydation comprend la formation d'un film contenant des agrégats de FeXN et de XO, puis un recuit.

**27.** Procédé selon l'une quelconque des revendications 19 à 26, prise en combinaison avec la revendication 20, **caractérisé par le fait que** le substrat amorphe est constitué essentiellement de X ou XN.

**Claims**

**1.** Thin, insulating, soft magnetic film of high magnetization, comprising an oxidized amorphous substrate in which Fe-rich ferromagnetic nanograins are immersed, **characterized in that** the nanograins are nitrided and have a diameter of less than 10 nm, and **in that** atomic percentage of nitrogen is equal to greater than 5 and less than or equal to 20.

**2.** Film according to Claim 1, **characterized in that** the nanograins constitute a crystalline phase of FeXN with X being preferably chosen from the following elements: Zr, Nb, Mo, Ru, Rh, Pd, Hf, Ta, W, Ir, Pt, Al, Si, Ti, V, Cr, Mn, Cu and the lanthanides.

**3.** Film according to either of Claims 1 and 2, **characterized in that** the nanograins have a body-centred cubic or body-centred tetragonal structure.

**4.** Film according to any one of Claims 1 to 3, taken in combination with Claim 12, **characterized in that** the amorphous substrate essentially consists of XO or XNO.

**5.** Film according to any one of Claims 1 to 4, **characterized in that** the amorphous phase represents less than 20% of the total volume of the thin film.

**6.** Film according to any one of Claims 1 to 5, **characterized in that** each element is present within the film, for example, in the following proportions in atomic percent: $Fe_aX_bN_cO_d$,
$45\% \leq a \leq 90\%$,
$1\% \leq b \leq 5 \%$
$5 \% \leq c \leq 20\%$

$5 \% \le d \le 30\%$
with $a + b + c + d = 100\%$.

7. Integrated circuit (IC), **characterized in that** it comprises at least one component (C) using a membrane (MB) incorporating a film (2) according to any one of Claims 1 to 6.

8. Integrated circuit (IC) according to Claim 7, **characterized in that** the component (C) is an inductive component (CL).

9. Integrated circuit (IC) according to Claim 8, **characterized in that** the membrane (MB) of the inductive component (CL) can be moved so as to vary the inductance of the component (CL).

10. Integrated circuit (IC) according to Claim 9, **characterized in that** the magnetic film (2) of the membrane (MB) has a high magnetic permeability $\mu'$ and low magnetic losses $\mu''$.

11. Integrated circuit (IC) according to Claim 8, **characterized in that** the membrane (MB) of the inductive component (CL) is fixed and forms a screening cover for the inductive component.

12. Integrated circuit (IC) according to Claim 11, **characterized in that** the magnetic film (2) of the membrane (MB) has a low magnetic permeability $\mu'$ and high magnetic losses $\mu''$.

13. Integrated circuit (IC) according to any one of Claims 8 to 12, **characterized in that** the membrane (MB) of the inductive component (CL) incorporates a magnetic film (2) of the FeHfNO type.

14. Integrated circuit (IC) according to Claim 7, **characterized in that** the membrane (MB) forms a cover for encapsulating the component (C).

15. Integrated circuit (IC) according to Claim 7, **characterized in that** the membrane (MB) forms a support for the component.

16. Integrated circuit (IC) according to Claim 7, **characterized in that** the component (C) is a capacitive component (CC) and **in that** the membrane (MB) forms the dielectric of the capacitive component (CC).

17. Integrated circuit (IC) according to any one of Claims 7 to 16, **characterized in that** it comprises at least two different components (C) using two different parts of the same membrane (MB).

18. Integrated circuit (IC) according to any one of Claims 7 to 17, **characterized in that** the membrane (MB) comprises the magnetic film (2) sandwiched between two passivation layers (21) and (22).

19. Process for obtaining a thin, soft magnetic film according to Claim 1, which process comprises the nitriding of Fe-rich ferromagnetic nanograins immersed in an amorphous substrate, the level of nitrogen enrichment lying in the range from 0.1% to 10%, and the selective oxidation of the amorphous substrate.

20. Process according to Claim 19, **characterized in that** the ferromagnetic nanograins are formed mainly from FeXN with X being preferably chosen from the following elements: Zr, Nb, Mo, Ru, Rh, Pd, Hf, Ta, W, Ir, Pt, Al, Si, Ti, V, Cr, Mn, Cu and the lanthanides.

21. Process according to Claim 19 or 20, **characterized in that** the nitriding is carried out by cathode or ion reactive sputtering.

22. Process according to Claim 21, **characterized in that** the nitriding is carried out in a magnetic field.

23. Process according to one of Claims 19 to 22, **characterized in that** the oxidation is carried out by cathode or ion reactive sputtering.

24. Process according to one of Claims 19 to 22, **characterized in that** the oxidation is carried out by selective diffusion of oxygen by heat treatment.

25. Process according to Claim 24, **characterized in that** the oxidation step comprises the formation of an FeXN/XO multilayer, followed by annealing.

26. Process according to Claim 24, **characterized in that** the oxidation step comprises the formation of a film containing FeXN and XO aggregates, followed by annealing.

27. Process according to any one of Claims 19 to 26, taken in combination with Claim 20, **characterized in that** the amorphous substrate essentially consists of X or XN.

**Patentansprüche**

1. Weicher magnetischer Dünnfilm mit starker Magnetisierung und isolierend, der ein amorphes Substrat umfasst, in das Fe-reiche ferromagnetische Nanokörner getaucht sind, **dadurch gekennzeichnet, dass** die Nanokörner nitriert sind und einen Durchmesser von weniger als 10 nm haben, und dadurch, dass der Stickstoffanteil in Atomprozent größer oder gleich 5 und kleiner oder gleich 20 ist.

2. Film nach Anspruch 1, **gekennzeichnet durch** die Tatsache, dass die Nanokörner eine kristalline Phase aus FeXN bilden, wobei X bevorzugt aus den folgenden Elementen ausgewählt ist: Zr, Nb, Mo, Ru, Rh, Pd, Hf, Ta, W, Ir, Pt, Al, Si, Ti, V, Cr, Mn, Cu und den Lanthaniden.

3. Film nach einem der Ansprüche 1 bis 2, **gekennzeichnet durch** die Tatsache, dass die Nanokörner eine kubische oder tetragonale zentrierte Struktur haben.

4. Film nach einem der Ansprüche 1 bis 3 in Kombination mit Anspruch 2, **gekennzeichnet durch** die Tatsache, dass das amorphe Substrat im Wesentlichen aus XO oder XNO besteht.

5. Film nach einem der Ansprüche 1 bis 4, **gekennzeichnet durch** die Tatsache, dass die amorphe Phase weniger als 20 % des Gesamtvolumens des Dünnfilms darstellt.

6. Film nach einem der Ansprüche 1 bis 5, **gekennzeichnet durch** die Tatsache, dass jedes Element innerhalb des Films in den folgenden Anteilen in Atomprozent vorhanden ist: $Fe_aX_bN_cO_d$ mit
   $45\ \% \leq a \leq 90\ \%$
   $1\ \% \leq b \leq 5\ \%$
   $5\ \% \leq c \leq 20\ \%$
   $5\ \% \leq d \leq 30\ \%$ mit $a + b + c + d = 100\ \%$

7. Integrierter Schaltkreis (CI), **gekennzeichnet durch** die Tatsache, dass er mindestens eine Komponente (C) umfasst, die eine Membran (MB) verwendet, in die ein Film (2) nach einem der Ansprüche 1 bis 6 integriert ist.

8. Integrierter Schaltkreis (CI) nach Anspruch 7, **gekennzeichnet durch** die Tatsache, dass die Komponente (C) eine induktive Komponente (CL) ist.

9. Integrierter Schaltkreis (CI) nach Anspruch 8, **gekennzeichnet durch** die Tatsache, dass die Membran (MB) der induktiven Komponente (CL) verschiebbar ist, um den induktiven Wert der Komponente (CL) variieren zu lassen.

10. Integrierter Schaltkreis (CI) nach Anspruch 9, **gekennzeichnet durch** die Tatsache, dass der magnetische Film (2) der Membran (MB) eine hohe magnetische Permeabilität µ' und geringe magnetische Verluste µ'' aufweist.

11. Integrierter Schaltkreis (CI) nach Anspruch 8, **gekennzeichnet durch** die Tatsache, dass die Membran (MB) der induktiven Komponente (CL) fest ist und eine Abschirmhaube der induktiven Komponente bildet.

12. Integrierter Schaltkreis (CI) nach Anspruch 11, **gekennzeichnet durch** die Tatsache, dass der magnetische Film (2) der Membran (MB) eine geringe magnetische Permeabilität µ' und hohe magnetische Verluste µ '' aufweist.

13. Integrierter Schaltkreis (CI) nach einem der Ansprüche 8 bis 12, **gekennzeichnet durch** die Tatsache, dass in die Membran (MB) der induktiven Komponente (CL) ein magnetischer Film (2) vom Typ FeHfNO integriert ist.

14. Integrierter Schaltkreis (CI) nach Anspruch 7, **gekennzeichnet durch** die Tatsache, dass die Membran (MB) eine Haube zum Verkapseln der Komponente (C) bildet.

15. Integrierter Schaltkreis (CI) nach Anspruch 7, **gekennzeichnet durch** die Tatsache, dass die Membran (MB) einen Träger für die Komponente (C) bildet.

16. Integrierter Schaltkreis (CI) nach Anspruch 7, **gekennzeichnet durch** die Tatsache, dass die Komponente (C) eine kapazitive Komponente (CC) ist und **durch** die Tatsache, dass die Membran (MB) das Dielektrikum der kapazitiven Komponente (CC) bildet.

17. Integrierter Schaltkreis (CI) nach einem der Ansprüche 7 bis 16, **gekennzeichnet durch** die Tatsache, dass er mindestens zwei verschiedene Komponenten (C) umfasst, die zwei verschiedene Teile der gleichen Membran (MB) verwenden.

18. Integrierter Schaltkreis (CI) nach einem der Ansprüche 7 bis 17, **dadurch gekennzeichnet, dass** die Membran (MB) den magnetischen Film (2) beinhaltet, der eingeschoben zwischen zwei Passivierungsschichten (21) und (22) angeordnet ist.

19. Verfahren zum Erhalten eines weichen magnetischen Dünnfilms nach Anspruch 1, wobei das Verfahren eine Nitrierung der Fe-reichen ferromagnetischen Nanokörner, die in ein amorphes Substrat getaucht sind, wobei die Stickstoffanreicherungsrate im Bereich zwischen 0,1 % und 10 % liegt, und eine selektive Oxidation des amorphen Substrats umfasst.

20. Verfahren nach Anspruch 19, **gekennzeichnet durch** die Tatsache, dass die ferromagnetischen Nanokörner aus FeXN bestehen, wobei X bevorzugt aus den folgenden Elementen ausgewählt ist: Zr, Nb, Mo, Ru, Rh, Pd, Hf, Ta, W, Ir, Pt, Al, Si, Ti, V, Cr, Mn, Cu und den Lanthaniden.

21. Verfahren nach Anspruch 19 oder 20, **gekennzeichnet durch** die Tatsache, dass die Nitrierung durch reaktive Kathoden- oder Ionenzerstäubung durchgeführt wird.

22. Verfahren nach Anspruch 21, **gekennzeichnet durch** die Tatsache, dass die Nitrierung in einem Magnetfeld durchgeführt wird.

23. Verfahren nach einem der Ansprüche 19 bis 22, **gekennzeichnet durch** die Tatsache, dass die Oxidation durch reaktive Kathoden- oder Ionenzerstäubung durchgeführt wird.

24. Verfahren nach einem der Ansprüche 19 bis 22, **gekennzeichnet durch** die Tatsache, dass die Oxidation durch selektive Sauerstoffdiffusion mittels Wärmebehandlung durchgeführt wird.

25. Verfahren nach Anspruch 24, **gekennzeichnet durch** die Tatsache, dass der Oxidationsschritt die Bildung einer FeXN/XO-Mehrfachschicht, gefolgt von Tempern, umfasst.

26. Verfahren nach Anspruch 24, **gekennzeichnet durch** die Tatsache, dass der Oxidationsschritt die Bildung eines Films, der FeXN- und XO-Aggregate enthält, gefolgt von Tempern, umfasst.

27. Verfahren nach einem der Ansprüche 19 bis 26 in Kombination mit Anspruch 20, **gekennzeichnet durch** die Tatsache, dass das amorphe Substrat im Wesentlichen aus XO oder XNO gebildet wird.

## FIG.1

CI

2  21  MB

22

1

SP   SP   SP   SP

SB

CL

## FIG.2

CI

21  2   MB

22

1

CL

SP   SP   SP   SP

SB

## FIG.3

CI

C

2  21  MB

22

1

SB

## FIG.4

CI

MB

21 2

22

C

1

SB

C

## FIG.5

CI

21 2

22

CM

MB

1

CM

CC

SP SP SP SP

CL

SB

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5573863 A
- US 5725685 A
- EP 1361586 A
- EP 1020878 A

**Littérature non-brevet citée dans la description**

- Soft-magnetic fluxguide materials. **F. Roozeboom.** Philips Journal of Research. Elsevier, 1998, vol. 51, 59-91